# EUROPÄISCHE PATENTANMELDUNG

(11) **EP 0 823 773 A2**
(43) Veröffentlichungstag der Anmeldung: **11.02.1998**
(21) Anmeldenummer: 97810412.3
(22) Anmeldetag: 26.06.1997
(51) Int. Cl.: H02M 7/519, H02M 7/00

(54) **Stromrichterschaltungsandordnung**

(30) Priorität: 09.08.1996 DE 19632173
(71) Anmelder: Asea Brown Boveri AG, 5401 Baden (CH)
(72) Erfinder: Ramezani, Ezatollah, Dr., 5103 Möriken (CH); Waldmeyer, Jürg, Dr., 5605 Dottikon (CH)
(74) Vertreter: Weibel, Beat

(57) **Zusammenfassung**

Es wird eine Stromrichterschahungsanordnung angegeben. Dadurch, dass die Stromanstiegsbegrenzungsinduktivität den zweiten Stapel mit Diode und Widerstand konzentrisch umgibt, wird ein äusserst kompakter Aufbau erreicht. Insbesondere kann die Induktivität als den Stapel umgebende Drahtspirale ausgeführt sein. Ein sehr kompakter Aufbau des Stromrichters ergibt sich weiterhin dadurch, dass der erste und zweite Stapel, d.h- der Stapel der Schalter und der Stapel der Beschaltung einem gemeinsamen Spannverband angehören.

## Beschreibung

### Technisches Gebiet

Die Erfindung bezieht sich auf das Gebiet der Leistungselektronik. Sie geht aus von einer Stromrichterschaltungsanordnung nach dem Oberbegriff des ersten Anspruchs.

### Stand der Technik

Eine gattungsgemässe Stromrichterschaltungsanordnung wird schon in der Europäischen Patentanmeldung EP 0 660 496 A2 beschrieben.

Eine derartige Stromrichterschaltungsanordnung umfasst mindestens einen Phasenbaustein, umfassend eine Serieschaltung mindestens zweier rückwärtsleitfähiger Schalter z.B. GTOs mit antiparallel angeordneter Diode, wobei ein mittlerer Knoten der Serieschaltung einen Lastanschluss bildet, sowie eine Beschaltung. Die Beschaltung umfasst mindestens eine Stromanstiegsbegrenzungsinduktivität, die in Serie mit den Schaltern angeordnet ist, und eine Serieschaltung eines Widerstandes und einer Beschaltungsdiode, die parallel zur Induktivität angeordnet ist. Im Rahmen der vorstehend genannten Patentanmeldung wird nun versucht, durch geschickte Anordnung und Zuordnung der Elemente einen niederinduktiven Aufbau zu erreichen. Ein möglichst niederinduktiver Aufbau ist insbesondere im Hinblick auf höhere Schaltfrequenzen und Flankensteilheiten anzustreben. Die Schalter bzw. die Dioden werden zu diesem Zweck zu je einem Stapel zusammengefasst. Die Beschaltung, d.h. Widerstände und Induktivitäten werden unterhalb der Stapel angeordnet.

### Darstellung der Erfindung

Aufgabe der vorliegenden Erfindung ist es, den Stand der Technik so weiterzubilden, dass eine Stromrichterschaltungsanordnung resultiert, die möglichst kompakt aufgebaut ist. Diese Aufgabe wird bei einer Stromrichterschaltungsanordnung der eingangs genannten Art durch die Merkmale des ersten Anspruchs gelöst.

Kern der Erfindung ist es also, dass die Stromanstiegsbegrenzungsinduktivität den zweiten Stapel mit Diode und Widerstand konzentrisch umgibt. Insbesondere kann die Induktivität als den Stapel umgebende Drahtspirale ausgeführt sein. Ein sehr kompakter Aufbau des Stromrichters ergibt sich dadurch, dass der erste und zweite Stapel, d.h. der Stapel der Beschaltung und der Stapel der Schalter einem gemeinsamen Spannverband angehören. Zur Kühlung können zwischen den einzelnen Elementen eines Stapels flüssigkeitsgekühlte Kühldosen vorgesehen werden. Bei der Verwendung eines Siliziumwiderstandes, der insbesondere in einem gemeinsamen Gehäuse mit der Beschaltungsdiode untergebracht ist, ergibt sich ein noch kompakterer Aufbau. Die Schalter umfassen rückwärtsleitende GTOs oder GTOs, zu denen antiparallel eine Freilaufdiode angeordnet ist. Diese kann auf demselben Wafer wie der GTO realisiert werden und in einem gemeinsamen Druckkontaktgehäuse untergebracht werden.

Der beim eingangs genannten Stand der Technik notwendige Beschaltungskondensator Cs kann bei der Erfindung z.B dadurch eliminiert werden, dass der GTO der Schalter beim Abschalten wie ein Transistor behandelt wird. Im Abschaltvorgang wird der Gate-Kathoden-Ubergang durch eine geeignete Stromsteilheit am Gate von Ladungsträgern freigeräumt, bevor der Rückkoppelungsmechanismus des GTOs Gelegenheit zu einer Anodenstrom-Einschnürung erhält und bevor durch laterale Inhomogenitäten im Aktivteil ein unkontrollierbares Durchzünden erfolgen kann. Zu diesem Zweck wird die Stromsteilheit am Gate so gewählt, dass das Freiräumen der Ladungsträger am Gate-Kathoden-Ubergang innerhalb von ≤ 1 µs erfolgt. Die Spannungssteilheit dV/dt wird hierbei durch den GTO selbst bestimmt und liegt in der Grössenordnung von einigen kV/µs. Wird der GTO auch beim Einschalten wie ein Transistor behandelt, das heisst, dass eine genügend hohe Stromsteilheit am Gate erzeugt wird (z-B. Erreichen des Laststromwertes innerhalb von 1 µs bis 2 µs), so kann auch die Grösse der Strombegrenzungsdrossel reduziert werden. Der Gate-Kathoden-Ubergang wird dadurch so schnell mit Ladungsträgern überschwemmt, dass der GTO wie ein Transistor einschaltet, ohne durch die sonst auftretenden lateralen Inhomogenitäten in der Stromdichte gefährdet zu werden.

Diese Art der Anteuerung ist auch unter der Bezeichnung "harte Ansteuerung" bekannt.

Nicht zu unterschätzen ist auch der Einfluss der antiparallel zum GTO geschalteten Freilaufdiode. Bei einem Stromrichter mit Gleichspannungszwischenkreis (U-Stromrichter) ist das Einschalten des GTOs immer mit dem Ausschalten der gegenüberliegenden Freilaufdiode verknüpft. Diese unterliegt betragsmässig derselben Stromsteilheit. Bei Elimination des Beschaltungskondensators wird das an der Diode auftretende dV/dt durch die Diode selbst bestimmt und liegt in der Grössenordnung von einigen kV/µs. Eine Verbesserung der Diodeneigenschaften lässt sich - wie auch beim GTO - durch Verwendung einer Stopschicht erreichen. GTO und Freilaufdiode weisen damit dieselbe Technologie auf und es bietet sich an, die beiden Elemente in demselben Druckkontaktgehäuse und insbesondere auf demselben Siliziumwafer zu integrieren. Ein weiteres Mittel zur Erhöhung der dI/dt-Tragfähigkeit der Diode beim Abschalten besteht in der Verwendung von lokalen Lebensdauereinstellungen (axial und lateral z.B. mittels Protonenbestrahlung).

Alle diese Massnahmen tragen zu einem äusserst kompakten Stromrichter bei. Weitere Ausführungsbeispiele ergeben sich aus den entsprechenden abhängigen Ansprüchen.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1**: Eine Ersatzschaltung einer Stromrichterschaltungsanordnung, für die die Erfindung geeignet ist;
- **Fig. 2**: Einen Ausschnitt aus einem erfindungsgemässen Aufbau eines Stromrichters.

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

### Wege zur Ausführung der Erfindung

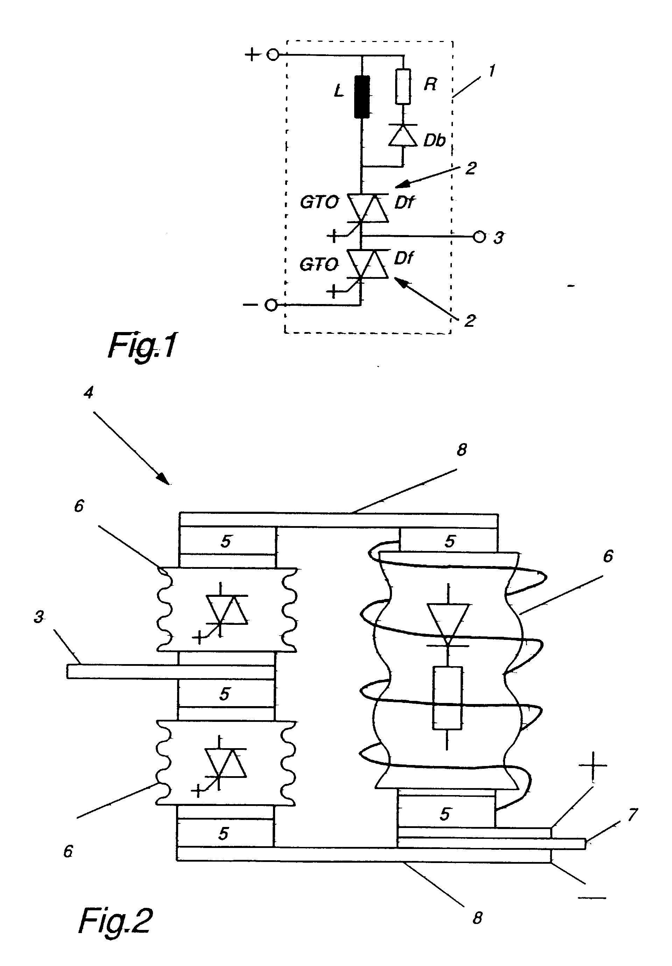

**Figur 1** zeigt ein Ersatzschaltbild einer Schaltung, für die die Erfindung vorteilhaft eingesetzt wird. Dargestellt ist ein Zweig oder Phasenbaustein 1 eines Stromrichters. Ein solcher Phasenhaustein, vom dem im Rahmen eines Stromrichter mehrere parallel geschaltet sein können, umfasst eine Serieschaltung von mindestens zwei Schaltern, insbesondere Abschaltthyristoren GTO mit antiparallel geschalteter Freilaufdiode Df. Die Serieschaltung der Schalter ist über eine Beschaltung an eine Gleichspannungsquelle mit einem Plusanschluss + und einem Minusanschluss - angeschlossen. Die Beschaltung dient dem Schutz der Schalter 2. Sie umfasst im Falle der Erfindunglediglich eine Stromanstiegsbegrenzungsdrossel L und parallel dazu eine Serieschaltung einer Beschaltungsdiode Db und eines Widerstandes R. Der mittlere, gemeinsame Knoten der Serieschaltung der Schalter 2 bildet einen Lastanschluss 3, an den eine Last, z.B. ein Drehstrommotor angeschlossen werden kann. Durch abwechselndes Schalten der Schalter 2 kann an den Lastanschluss entweder der Plusanschluss oder der Minusanschluss der Gleichspannungsquelle geschaltet werden, so dass an der Last eine Wechselspannung entsteht. Die Wirkungsweise einer solchen Schaltung wird als bekannt vorausgesetzt und an dieser Stelle deshalb nicht mehr weiter erläutert.

Gelingt es, einen solchen Stromrichter oder zumindest die Zweige oder Phasenbausteine kompakt und verlustarm aufzubauen, so steht der Weg zu höheren Schaltfrequenzen offen. Dadurch verbessert sich die Regeldynamik und der Aufwand zur Beherrschung der Verzerrungsblindleistung kann vermindert werden.

Nach der Erfindung wird nun ein äusserst kompakter Aufbau dadurch erreicht, dass die Schalter 2, d.h. GTOs mit Freilaufdioden Df, einen ersten Stapel und die Beschaltungsdiode Db und der Widerstand R einen zweiten Stapel bilden und dass die Induktivität L den zweiten Stapel konzentrisch umgibt. Dies kann beispielsweise durch eine Drahtspirale erreicht werden. Damit ergibt sich ein Aufbau, wie er in Figur 2 dargestellt ist: Zwischen zwei elektrisch leitenden Druckkontaktplatten 8 sind die beiden Stapel angeordnet. Vorzugsweise sind sie Teil eines gemeinsamen Spannverbandes 4. Die in Figur 2 untere Druckkontaktplatte bildet gleichzeitig den Minusanschluss - der Gleichspannungsquelle. Im Bereich des zweiten Stapels ist eine Isolationsschicht 7 vorgesehen, auf welche eine weitere Kontaktplatte, die mit dem Plusanschluss der Gleichspannungsquelle verbunden ist, angebracht ist.

Die GTOs mit antiparalleler Freilaufdiode Df sind vorzugsweise in einem gemeinsamen Druckkontaktgehäuse 6 untergebracht. Die beiden Elemente können auch auf einem gemeinsamen Wafer integriert werden. Zwischen zwei benachbarten Gehäusen und zwischen den Drukkontaktplatten 8 und den Drukkontaktgehäusen 6 können Kühlkörper 5 z.B. in Form von flüssigkeitsdurchflossenen Kühldosen vorgesehen sein. Der Widerstand R und die Beschaltungsdiode Db sind ebenfalls in einem Druckontaktgehäuse untergebracht. Besonders bevorzugt werden Widerstände aus Silizium, die durch besondere Prozesse (z.B. Golddiffusion oder sehr starke Elektronenbestrahlung) im für die Praxis relevanten Temperaturberreich eine ausreichende Widerstandskonstanz aufweisen. Dieser Widerstand R mit der in Serie geschalteten Beschaltungsdiode Db absorbiert beim Abschalten der Schalter die in der Induktivität gespeicherte Energie und reduziert dadurch die Überspannung am Schalter. Die Grösse des Widerstandes R richtet sich nach der zulässigen Spannungsüberhöhung und nach der Zeit, innerhalb derer die Energie in der Induktivität abgebaut werden soll. Ein besonderer Vorteil bei der Verwendung eines Silizium-Widerstandes liegt darin, dass für das Gehäuse ein Druckkontaktgehäuse verwendet werden kann. Die Überspannungs-Schutzeinheit, Widerstand R und Diode Db, kann somit die Stromanstiegsbegrenzungsdrossel L beim Abschalten nahezu induktionsfrei überbrücken.

### Bezugszeichenliste

- 1: Phasenbaustein, Stromrichterzweig
- 2: Schalter
- 3: Lastanschluss
- 4: Spannverband
- 5: Kühlkörper
- 6: Druckkontaktgehäuse
- 7: Isolationsschicht
- 8: Druckkontaktplatte
- L: Strombegrenzungsinduktivität
- R: Widerstand
- Db: Beschaltungsdiode
- Df: Freilaufdiode
- GTO: Abschaltthyristor
- +: Plusanschluss
- -: Minusanschluss

## Patentansprüche

1. Stromrichterschaltungsanordung umfassend mindestens einen Phasenbaustein (1), der an eine Gleichspannungsquelle anschliessbar ist und eine Serieschaltung von mindestens zwei Schaltern (2), insbesondere Abschaltthyristoren (GTO) mit antiparallel geschalteter Freilaufdiode (Df), und wenigstens eine Strombegrenzungsinduktivität (L), zu welcher Strombegrenzungsinduktivität (L) eine Serieschaltung eines Widerstandes (R) und einer Beschaltungsdiode (Db) parallel geschaltet ist, umfasst, wobei ein mittlerer Knoten der Serieschaltung der Schalter (2) einen Lastanschluss (3) bildet, die Schalter (2) einen ersten Stapel und die Serieschaltung der Beschaltungsdiode (Db) und des Widerstandes (R) einen zweiten Stapel bilden; dadurch gekennzeichnet, dass die Induktivität (L) den zweiten Stapel konzentrisch umgibt.

2. Schaltungsanordnung nach Anspruch 1, dadurch gekennzeichnet, dass die Induktivität (L) als Drahtspirale ausgebildet ist.

3. Schaltungsanordnung nach Anspruch 1 oder 2, dadurch gekennzeichnet, dass der erste und der zweite Stapel einem gemeinsamen Spannverband (4) angehören.

4. Schaltungsanordnung nach Anspruch 1, 2 oder 3, dadurch gekennzeichnet, dass zwischen den Schaltern (2) und zwischen der Beschaltungsdiode (Db) und dem Widerstand (R) Kühlkörper (5), insbesondere flüssigkeitsgekühlte Kühlkörper, eingefügt sind.

5. Schaltungsanordnung nach einem der Ansprüche 1 bis 4, dadurch gekennzeichnet, dass der Widerstand (R) ein Siliziumwiderstand ist und insbesondere mit der Beschaltungsdiode (Db) in einem gemeinsamen Druckkontaktgehäuse (6) untergebracht ist.

6. Schaltungsanordnung nach einem der Ansprüche 1 bis 5, dadurch gekennzeichnet, dass die Abschaltthyristoren (GTO) und die entsprechenden Freilaufdioden (Df) in einem gemeinsamen Druckkontaktgehäuse (6) und insbesondere auf einem gemeinsamen Siliziumwafer integriert sind.
